# EUROPÄISCHE PATENTSCHRIFT

(11) **EP 0 792 009 B1**
(45) Veröffentlichungstag und Bekanntmachung des Hinweises auf die Patenterteilung: **30.05.2001**
(21) Anmeldenummer: 97101935.1
(22) Anmeldetag: 06.02.1997
(51) Int. Cl.: H03B 5/18, H01P 1/20, H04B 1/26

(54) **Oszillatorschaltung**
Oscillator circuit
Circuit oscillateur

(30) Priorität: 22.02.1996 DE 19606684
(43) Veröffentlichungstag der Anmeldung: 27.08.1997
(73) Patentinhaber: Infineon Technologies AG, 81669 München (DE)
(72) Erfinder: Heilmann, Thomas, 80638 München (DE); Bexley, Adam, Hook Hants RG 27 8DS (GB)
(74) Vertreter: Zedlitz, Peter, Dipl.-Inf.

(56) Entgegenhaltungen:
- US-A- 4 353 038
- US-A- 5 138 284
- PATENT ABSTRACTS OF JAPAN vol. 016, no. 185 (E-1197), 6.Mai 1992 & JP 04 022201 A (MATSUSHITA ELECTRIC IND CO LTD), 27.Januar 1992,

## Beschreibung

Bislang wurden insbesondere in integrierten Schaltkreisen für Hochfrequenzanwendungen symmetrische Oszillatoren in kapazativer Dreipunktschaltung, sogenannte symmetrische Collpit-Oszillatoren, verwendet. Ein derartiger integrierter Schaltkreis ist beispielsweise der Typ S 042 der Firma Siemens, welcher beispielsweise in dem Datenbuch "Integrierte Schaltungen für die Unterhaltungselektronik 1986/87", Seiten 43 bis 48 beschrieben ist. Im Prinzip besteht ein derartiger Collpit-Oszillator aus zwei Transistoren, deren Basen und Kollektoren über jeweils einen Widerstand mit einem Versorgungspotential verbunden sind und deren Emitter über jeweils einen Widerstand an ein Bezugspotential angeschlossen sind. Zwischen Basis und Emitter der beiden Transistoren ist dabei jeweils ein Kondensator geschaltet, wobei zwischen die Emitter der beiden Transistoren ein weiterer Kondensatorgesetzt wird. Ein Schwingkreis ist schließlich zwischen den Basen der beiden Transistoren angeordnet.

Der Vorteil bei diesem Oszillatortyp ist, daß die Spule keine oder nur wenige Anzapfungen benötigt, die darüber hinaus hinsichtlich ihrer Genauigkeit unkritisch sind. Nachteilig ist allerdings, daß die Emitterwiderstände der beiden Transistoren den Schwingkreis bedämpfen und damit ein erhöhtes Weitab-Phasenrauschen hervorrufen.

Hinsichtlich des Weitab-Phasenrauschens sind symmetrische Oszillatoren in induktiver Dreipunkt-Schaltung, sogenannte Hartley-Oszillatoren, wesentlich günstiger. Das Grundprinzip des Hartley-Oszillators ist ebenso wie das Grundprinzip des Collpit-Oszillators, beispielsweise in U. Tietze, Ch. Schenk, "Electronic Circuits-Design and Applications", Seiten 413 und 414 beschrieben. Nachteilig bei Hartley-Oszillatoren ist, daß insbesondere bei symmetrischer Ausführung hohe Anforderungen an die Induktivität des Schwingkreises und insbesondere an die Genauigkeit der Abgriffe gefordert werden. Die Herstellung derartiger Induktivitäten für den Hochfrequenzbereich erfordern daher einen verhältnismäßig hohen Aufwand.

In der US-A-4,353,038 ist ein Oszillator mit einem U-förmigen Streifenleiter gezeigt. Für Breitbandanwendungen sind verschiedene Rückkopplungsnetzwerke an den Resonator schaltbar angeschlossen. Die Anschlüsse sind nicht symmetrisch ausgeführt. Weitere U-förmige Streifenleiter zur Verwendung als Resonatoren für Oszillatorschaltkreise sind in der US-A-5,138,284 gezeigt, in der ein Kondensator an die Außenanschlüsse des U-förmigen Streifenleiters angeschlossen ist, sowie in der Literaturstelle Patent Abstracts of Japan, Vol. 16, No. 185(E-1197), 6. Mai 1992, JP-A-04-022201, in der ein U-förmiger Streifenleiter dargestellt ist, der Maßnahmen zur Einstellung variabler Leitungslänge aufweist.

Aufgabe der Erfindung ist es, eine Oszillatorschaltung anzugeben, bei der trotz Verwendung von Induktivitäten mit Abgriffen der Herstellungsaufwand gering ist.

Die Aufgabe wird durch eine Oszillatorschaltung gemäß Patentanspruch 1 gelöst. Ausgestaltungen und Weiterbildungen des Erfindungsgedankens sind Gegenstand von Unteransprüchen.

Eine erfindungsgemäße Oszillatorschaltung enthält einen Schwingkreis mit mindestens einer Kapazität sowie eine Induktivität mit zwei Hauptanschlüssen, einer Mittenanzapfung sowie zwei symmetrisch angeordneten weiteren Anzapfungen. Die Induktivität wird dabei als U-förmiger Streifenleiter ausgebildet, wobei die Mittenanzapfung am Umkehrpunkt des U-förmigen Streifenleiters angeordnet wird. Die Hauptanschlüsse befinden sich an den Schenkelenden des U-förmigen Streifenleiters. Die weiteren Anzapfungen erfolgen jeweils in gleicher Entfernung von dem jeweiligen Schenkelende.

Bevorzugt ist die Oszillatorschaltung symmetrisch ausgebildet und arbeitet insbesondere nach dem Hartley-Prinzip.

Bei einer bevorzugten Ausführungsform ist vorgesehen, daß die Mittenanzapfung über einen Widerstand mit einem Bezugspotential und die weiteren Anzapfungen mit dem Emitter jeweils eines der beiden Transistoren verbunden ist. Die Hauptanschlüsse des U-förmigen Streifenleiters sind dabei zum einen über einen Kondensator miteinander und zum anderen über jeweils einen weiteren Kondensator mit der Basis jeweils eines der beiden Transistoren verschaltet. Darüber hinaus sind die Basen und Kollektoren der beiden Transistoren über jeweils einen weiteren Widerstand mit einem Versorgungspotential verbunden. Anstelle der Widerstände können in gleicher Weise auch Strombegrenzungselemente oder Stromquellen eingesetzt werden.

Der Oszillator ist insbesondere für den Einsatz in einem integrierten Schaltkreis vorgesehen.

Der U-förmige Streifenleiter wird dann bevorzugt unter dem integrierten Schaltkreis angeordnet.

Der Vorteil einer U-förmigen Ausbildung des Streifenleiters liegt zum einen in einer mit hoher Genauigkeit und einfach durchzuführenden Plazierung der Mittenanzapfung und der weiteren Anzapfungen, in einer hohen Symmetrie und in einer sehr guten Reproduzierbarkeit. Der Vorteil der induktiven Dreipunkt-Schaltung wiederum liegt in der niedrigen ohmschen Belastung des Schwingkreises, da der gemeinsame Emitterwiderstand wechselspannungsmäßig nicht wirksam ist, was zu einem verbesserten Weitab-Phasenrauschen führt. Das Anordnen des U-förmigen Streifenleiters unter einer integrierten Schaltung hat schließlich den Vorteil einer Abschirmwirkung durch den integrierten Schaltkreis.

Die Erfindung wird nachfolgend anhand der in den Figuren der Zeichnung dargestellten Ausführungsbeispiels näher erläutert. Es zeigt:
Figur 1 den erfindungsgemäßen Oszillator in einem Schaltbild und
Figur 2 den Aufbau der Induktivität bei dem Oszillator nach Figur 1.

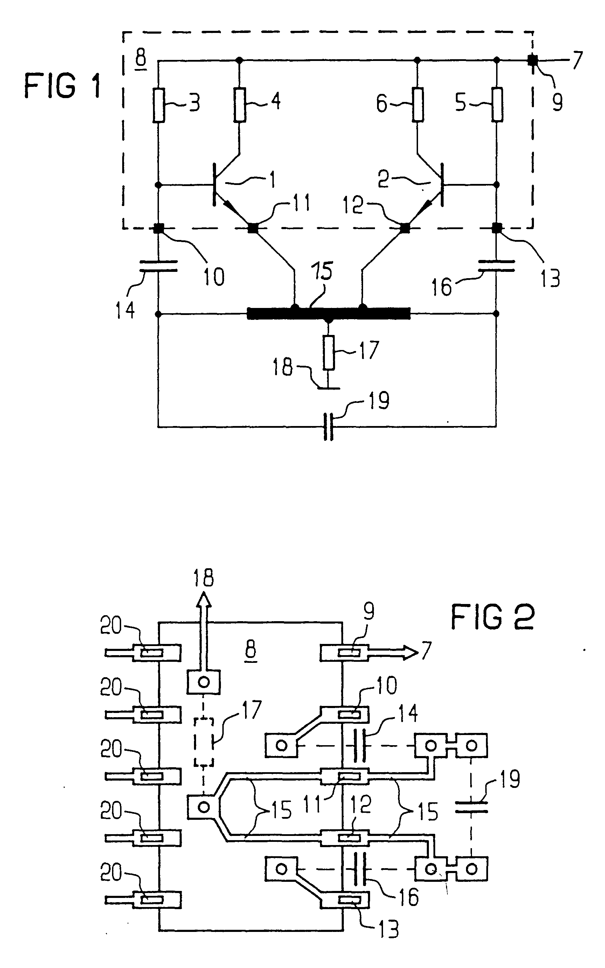

Bei dem Ausführungsbeispiel gemäß Figur 1 wird von einem symmetrischen Hartley-Oszillator ausgegangen. Dieser umfaßt zwei Bipolartransistoren 1 und 2 vom npn-Typ. Basis und Kollektor des Transistors 1 sind über jeweils einen Widerstand 3 bzw. 4 in gleicher Weise wie Basis und Emitter des Transistors 2 über jeweils einen Widerstand 5 bzw. 6 an ein Versorgungspotential 7 angeschlossen. Die Transistoren 1 und 2 sowie die Widerstände 3 bis 6 sind in eine integrierte Schaltung 8 mitintegriert. Die integrierte Schaltung 8 umfaßt weitere Schaltungsteile, die jedoch der Übersichtlichkeit halber nicht im einzelnen dargestellt sind. Das Versorgungspotential 7 wird über einen Anschluß 9 den in der integrierten Schaltung 8 enthaltenen Teilen der erfindungsgemäßen Oszillatorschaltung zugeführt. Des weiteren sind Basis und Emitter des Transistors 1 sowie Basis und Emitter des Transistors 2 über jeweils einen Anschluß 10, 11, 12 bzw. 13 nach außen geführt. Der mit der Basis des Transistors 1 verbundene Anschluß 10 ist extern über einen Kondensator 14 mit einem Hauptanschluß einer Induktivität 15 gekoppelt. Der andere Hauptanschluß der Induktivität 15 ist über einen Kondensator 16 mit dem Anschluß 13 der integrierten Schaltung 8 gekoppelt, wobei der Anschluß 13 seinerseits mit der Basis des Transistors 2 verbunden ist.

Die Induktivität 15 weist darüber hinaus eine Mittenanzapfung auf, die über einen Widerstand 17 mit einem Bezugspotential 18 gekoppelt ist. Darüber hinaus sind bei der Induktivität 15 zwei weitere Anzapfungen vorgesehen, die symmetrisch zur Mittenanzapfung angeordnet sind. Diese weiteren Anzapfungen sind mit den Anschlüssen 11 und 12 der integrierten Schaltung 8 verbunden, die ihrerseits innerhalb der integrierten Schaltung 8 an den Emitter des Transistors 1 bzw. an den Emitter des Transistors 2 angeschlossen sind. Zwischen die beiden Hauptanschlüsse der Induktivität 15 ist schließlich eine Kapazität 19 geschaltet, die zusammen mit der Induktivität 15 einen Schwingkreis bildet.

Gemäß Figur 2 ist die Schaltungsanordnung nach Figur 1 beispielsweise mechanisch derart aufgebaut, daß der integrierte Schaltkreis 8 ein Dual-Inline-Gehäuse mit zehn Anschlüssen umfaßt. Neben den Anschlüssen 9 bis 13, die in einer Reihe liegen, sind noch weitere Anschlüsse 20, die dem gegenüber in einer Reihe liegen, vorgesehen. Die Anschlüsse 20 und 9 bis 13 sind auf einer Seite einer nicht näher dargestellten Leiterplatte auf entsprechende Leiterbahnen aufgelötet. Die Leiterbahnen sind in der Zeichnung durch entsprechende schwarze Flächen dargestellt.

Die Induktivität 15 ist dabei erfindungsgemäß als U-förmiger Streifenleiter mit zwei zueinander parallel liegenden, die Schenkel des U-förmigen Streifenleiters bildenden Leiterbahnen, die einerseits jeweils spitz auf einen gemeinsamen Anschlußpad zulaufen und die andererseits jeweils abgewinkelt voneinander weg auf jeweils einen Anschlußpad führen. Der gemeinsame Anschlußpad dient zur Befestigung eines Anschlusses des Widerstandes 17, dessen anderer Anschluß ebenfalls über einen entsprechenden Anschlußpad und eine Leiterbahn an das Bezugspotential gelegt ist. Die Anschlußpads an den jeweiligen Schenkelenden sind zum einen über jeweils eine Leiterbahn mit jeweils einem von zwei weiteren Anschlußpads verbunden, zwischen die der Kondensator 19 geschaltet ist. Die unmittelbar am Schenkelende des U-förmigen Streifenleiters 15 angebrachten Anschlußpads sind jeweils mit einem Anschluß des Kondensators 14 bzw. 15 verbunden. Der jeweils andere Anschluß der Kondensatoren 14 und 15 ist mit einem über eine Leiterbahn mit dem Anschluß 10 bzw. 13 der integrierten Schaltung 8 verschalteten Anschlußpad verbunden.

Der U-förmige Streifenleiter 15 ist beim Ausführungsbeispiel so angeordnet, daß von dem integrierten Schaltkreis 8 teilweise überdeckt wird. In gleicher Weise ist aber auch bei entsprechender Anordnung der Anschlüsse 11, 12 der integrierten Schaltung 8 eine Ausgestaltung möglich, bei der der U-förmige Streifenleiter 15 fast vollständig von dem integrierten Schaltkreis 8 überdeckt wird.

Der integrierte Schaltkreis 8 ist dabei auf einer Seite der nicht dargestellten Leiterplatte direkt an den Anschlußpads angelötet, während die Kondensatoren 14, 15 und 19 sowie der Widerstand 17 auf der anderen Seite der Leiterplatte angeordnet sind und die Befestigung derart erfolgt, daß die Anschlüsse der Kondensatoren 14, 15 und 19 sowie des Widerstandes 17 durch Bohrungen im Bereich der Anschlußpads geführt sind und an diesen festgelötet sind. Die weiteren Abgriffe der Induktivität 15 entstehen also durch Einlöten des integrierten Schaltkreises 8 an der entsprechenden Stelle. Dabei liegen bevorzugt die beiden Anschlüsse 11 und 12 des integrierten Schaltkreises 8, die mit den Emittern der Transistoren 1 und 2 verbunden sind, direkt nebeneinander. Jedoch können zwischen diesen beiden Anschlüssen 11 und 12 aber auch nicht hochfrequente Anschlüsse des integrierten Schaltkreises 8 sich befinden. Die im Ausführungsbeispiel dargestellte Anordnung mit den unmittelbar nebeneinanderliegenden Anschlüssen 11 und 12 sowie die direkt daneben befindlichen Anschlüsse 10 und 13, die mit den Basen der Transistoren 1 und 2 verbunden sind, ermöglicht einen sehr kompakten Aufbau der Oszillatorschaltung sowie eine äußerst kurze Leitungsführung, die unerwünschte äußere Einflüsse möglichst gering hält.

Somit zeichnet sich die erfindungsgemäße Oszillatorschaltung durch eine hohe Kompaktheit durch eine geringere Empfindlichkeit gegenüber äußeren Einflüssen, eine gute Selbstabschirmung, geringes Rauschen und hohe Reproduzierbarkeit aus. Der Streifenleiter selbst ist mit hoher Genauigkeit und Reproduzierbarkeit sowie auf einfache Weise herzustellen.

## Patentansprüche

1. Oszillatorschaltung mit einem eine Kapazität (19) und eine Induktivität (15) aufweisenden Schwingkreis, bei der
- die Induktivität (15) zwei Hauptanschlüsse, eine Mittenanzapfung sowie zwei zur Mittenanzapfung symmetrisch angeordnete weitere Anzapfungen aufweist, wobei die Hauptanschlüsse der Induktivität (15) mit der Kapazität (19) gekoppelt sind und jeweils zwischen einen der Hauptanschlüsse und eine der weiteren Anzapfungen eine Basis-Emitter-Strecke eines Transistors (1, 2) gekoppelt ist,
- die Induktivität (15) als U-förmiger Streifenleiter ausgebildet ist,
- die Mittenanzapfung am Umkehrpunkt des U-förmigen Streifenleiters angeordnet ist und an ein Bezugspotential (18) gekoppelt ist,
- die Hauptanschlüsse an den Schenkelenden des U-förmigen Streifenleiters angeordnet sind und
- die weiteren Anzapfungen jeweils in gleicher Entfernung von dem jeweiligen Schenkelende sich befinden.

2. Oszillatorschaltung nach Anspruch 1,
**dadurch gekennzeichnet**, daß die Oszillatorschaltung symmetrisch und vom Hartley-Typ ist.

3. Oszillatorschaltung nach Anspruch 2,
**dadurch gekennzeichnet**, daß die Mittenanzapfung über einen Widerstand (17) mit dem Bezugspotential (18) verbunden ist,
daß die weiteren Anzapfungen mit dem Emitter jeweils eines Transistors (1, 2) verbunden sind,
daß die Hauptanschlüsse der Induktivität (15) zum einen über einen die Kapazität bildenden Kondensator (19) miteinander und zum anderen über jeweils einen weiteren Kondensator (14, 16) mit der Basis jeweils eines der beiden Transistoren (1, 2) verbunden sind und
daß die Basen und Kollektoren der beiden Transistoren (1, 2) über jeweils einen Widerstand (3, 4, 5, 6) mit einem Versorgungspotential (7) verbunden sind.

4. Oszillatorschaltung nach einem der Ansprüche 1 bis 3,
**dadurch gekennzeichnet**, daß die Oszillatorschaltung zumindest teilweise in einen integrierten Schaltkreis (8) integriert ist.

5. Oszillatorschaltung nach Anspruch 4,
**dadurch gekennzeichnet**, daß der U-förmige Streifenleiter (15) unter dem integrierten Schaltkreis (8) angeordnet ist.

## Claims

1. Oscillator circuit with a resonant circuit having a capacitor (19) and an inductor (15), in which oscillator circuit
- the inductor (15) has two main terminals, a centre tap and two further taps arranged symmetrically relative to the centre tap, the main terminals of the inductor (15) being coupled to the capacitor (19) and a base-emitter path of a transistor (1, 2) being coupled between in each case one of the main terminals and one of the further taps,
- the inductor (15) is constructed as a U-shaped stripline,
- the centre tap is arranged at the turning point of the U-shaped stripline and is coupled to a reference potential (18),
- the main terminals are arranged at the limb ends of the U-shaped stripline, and
- the further taps are respectively located at the same distance from the respective limb end.

2. Oscillator circuit according to Claim 1, characterized in that the oscillator circuit is symmetrical and of the Hartley type.

3. Oscillator circuit according to Claim 2, characterized in that the centre tap is connected via a resistor (17) to a reference potential (18), in that the further taps are connected to the emitter of in each case one transistor (1, 2), in that the main terminals of the inductor (15) are connected, on the one hand, to one another via a capacitor (19) which forms the capacitance, and are connected, on the other hand, to the base of in each case one of the two transistors (1, 2) via in each case one further capacitor (14, 16), and in that the bases and collectors of the two transistors (1, 2) are connected to a supply potential (7) via in each case one resistor (3, 4, 5, 6).

4. Oscillator circuit according to one of Claims 1 to 3, characterized in that the oscillator circuit is integrated at least partially into an integrated circuit (8).

5. Oscillator circuit according to Claim 4, characterized in that the U-shaped stripline (15) is arranged below the integrated circuit (8).

## Revendications

1. Circuit oscillateur comprenant un circuit oscillant présentant une capacité (19) et une inductance (15), dans lequel :
l'inductance (15) présente deux bornes de raccordement principal, un prélèvement central ainsi que deux autres prélèvements disposés symétriquement par rapport au prélèvement central, les bornes de raccordement principal de l'inductance (15) étant couplées à la capacité (19) et étant à chaque fois couplées entre l'une des bornes de raccordement principal et l'un des autres prélèvements d'un parcours base-émetteur d'un transistor (1, 2),
l'inductance (15) est configurée comme conducteur en ruban en forme de U,
le prélèvement central est disposé au point de retournement du conducteur en ruban en forme de U et est couplé à un potentiel de référence (18),
les bornes de raccordement principal sont disposées aux extrémités des branches du conducteur en ruban en forme de U, et
les autres prélèvements sont chacun situés à même distance de l'extrémité de la branche correspondante.

2. Circuit oscillateur selon la revendication 1, caractérisé en ce que le circuit oscillateur est symétrique et du type Hartley.

3. Circuit oscillateur selon la revendication 2, caractérisé en ce que le prélèvement central est relié au potentiel de référence (18) par l'intermédiaire d'une résistance (17),
- en ce que les autres prélèvements sont reliés à chaque fois à l'émetteur d'un transistor (1, 2),
- en ce que les bornes de raccordement principales de l'inductance (15) sont reliées d'une part l'une à l'autre par l'intermédiaire d'un condensateur (19) formant la capacité et d'autre part à chaque fois à la base de l'un des deux transistors (1, 2) par l'intermédiaire à chaque fois d'un autre condensateur (14, 16), et
- en ce que les bases et les collecteurs des deux transistors (1, 2) sont reliés par l'intermédiaire à chaque fois d'une résistance (3, 4, 5, 6) à un potentiel d'alimentation (7).

4. Circuit oscillateur selon l'une des revendications 1 à 3, caractérisé en ce que le circuit oscillateur est au moins partiellement intégré dans un circuit intégré (8).

5. Circuit oscillateur selon la revendication 4, caractérisé en ce que le conducteur (15) en ruban en forme de U est disposé en dessous du circuit intégré (8).
